# EUROPÄISCHE PATENTSCHRIFT

(11) **EP 4 105 667 B1**
(45) Veröffentlichungstag und Bekanntmachung des Hinweises auf die Patenterteilung: **01.11.2023**
(21) Anmeldenummer: 22176813.8
(22) Anmeldetag: 01.06.2022
(51) Int. Cl.: G01R 31/12

(54) **VERFAHREN ZUM TEILENTLADUNGSMESSEN ZUMINDEST EINES MITTELSPANNUNGSKABELS EINES MITTELSPANNUNGSNETZES**
METHOD FOR MEASURING THE PARTIAL DISCHARGE OF AT LEAST ONE MEDIUM VOLTAGE CABLE OF A MEDIUM VOLTAGE NETWORK
PROCÉDÉ DE MESURE DE LA DÉCHARGE PARTIELLE D'AU MOINS UN CÂBLE MOYENNE TENSION D'UN RÉSEAU MOYENNE TENSION

(30) Priorität: 01.06.2021 DE 102021114223
(43) Veröffentlichungstag der Anmeldung: 21.12.2022
(73) Patentinhaber: Westnetz GmbH, 44139 Dortmund (DE)
(72) Erfinder: Scholten-Reintjes, Matthias, 47055 Dusiburg (DE); Bleier, Alina, 44265 Dortmund (DE); Lührsen, Helmut, 44130 Essen (DE); Temmen, Lucas Bernhard, 48488 Emsbüren (DE)
(74) Vertreter: Bals & Vogel Patentanwälte PartGmbB

(56) Entgegenhaltungen:
- WO-A1-2020/209513

## Beschreibung

Die Erfindung betrifft ein Verfahren zum Teilentladungsmessen zumindest eines Mittelspannungskabels eines Mittelspannungsnetzes. Ferner betrifft die Erfindung ein System umfassend eine Messvorrichtung zur Durchführung einer Teilentladungsmessung und einen Computer, wobei das System zum Durchführen dieses Verfahrens eingerichtet ist, sowie ein Computerprogrammprodukt und ein computerlesbares Speichermedium.

Mittelspannungsnetze sind ein Teil des Stromnetzes zur Verteilung der elektrischen Energie. Ein Mittelspannungsnetz ist aus mehreren Mittelspannungskabeln aufgebaut, die jeweils durch entsprechende Knotenpunkte in Form von Netzstationen miteinander verbunden sind. Unter einer Mittelspannung wird dabei eine Hochspannung im Bereich von zumindest 1 kV bis einschließlich 60 kV verstanden. Die Mittelspannungskabel im Mittelspannungsnetz müssen entsprechend für eine derartige Spannung geeignet sein. Derartige Mittelspannungskabel werden üblicherweise unterirdisch verlegt. Ihr optischer Zustand ist daher normalerweise nicht von außen bestimmbar ohne die Mittelspannungskabel freizulegen.

Eine durchgehende Verfügbarkeit des Mittelspannungsnetzes ist eine wichtige Voraussetzung für eine zuverlässige Stromversorgung des von dem Mittelspannungsnetz erfassten Versorgungsgebiets. Beispielsweise ein Versagen der Isolation der Mittelspannungskabel im Mittelspannungsnetz kann zu gefährlichen Situationen und schweren Beschädigungen führen. Teilentladungen sind einer der Hauptfaktoren für eine Verschlechterung in den Isolationen der Mittelspannungskabel. Dies kann letztendlich hohe Kosten verursachen. Daher ist es von großer Bedeutung, dass der Zustand der Mittelspannungskabel regelmäßig kontrolliert wird.

Wenn Arbeiten an einem Mittelspannungskabel des Mittelspannungsnetzes durchgeführt werden, ist normalerweise eine Spannungsprüfung des Mittelspannungskabels nach Abschluss der Arbeiten erforderlich. Zudem ist nach der Inbetriebnahme oder Wiederinbetriebnahme nach einer Störung eines Mittelspannungskabels normalerweise eine Spannungsprüfung des Mittelspannungskabels erforderlich. Im Anschluss an die Spannungsprüfung werden üblicherweise auch Teilentladungsmessungen zur Zustandserfassung des Mittelspannungskabels durchgeführt. Auch sonst bzw. unabhängig von vorgeschriebenen Spannungsprüfungen werden Teilentladungsmessungen an Mittelspannungskabeln regelmäßig durchgeführt, um die erwähnten hohen Kosten bei einer möglichen schweren Beschädigung der Mittelspannungskabel zu vermeiden.

Gemäß der Norm IEC 60270 sind Teilentladungen lokale elektrische Entladungen, die die Isolierung zwischen Leitern nur teilweise überbrücken und in der Nähe eines Leiters auftreten können oder nicht. Sie können eine Folge von lokalen elektrischen Feldstärkeüberhöhungen innerhalb der Isolation oder auf der Oberfläche der Isolation der Mittelspannungskabel sein.

Die Teilentladungsmessung ist ein nichtinvasives Verfahren, mit dem eine zuverlässige Diagnose des Isolationszustands der Mittelspannungskabel des Mittelspannungsnetzes möglich ist. Da Teilentladungen häufig bereits lange vor einem Defekt der Isolation auftreten, können entsprechende Teilentladungsmessungen üblicherweise zuverlässig für eine rechtzeitige Entscheidung bezüglich einer Reparatur oder eines Austausches der Mittelspannungskabel treffen, bevor es zu einem unerwarteten Ausfall eines Mittelspannungskabels kommt. Das Erkennen von Teilentladungen ist daher von großer Bedeutung für den störungsfreien Betrieb des Mittelspannungsnetzes.

Typischerweise wird ein Kabelmesswagen für die Teilentladungsmessungen eingesetzt. Dieser Kabelmesswagen muss sich zur Netzstation zwischen Mittelspannungskabeln begeben und dort mithilfe einer Messvorrichtung eine Teilentladungsmessung vornehmen. Aufgrund der sehr hohen Anzahl an Mittelspannungskabeln ist typischerweise eine überaus hohe Anzahl an Teilentladungsmessungen an den verschiedenen Netzstationen notwendig, um den Zustand des Mittelspannungsnetzes laufend zu überwachen. Ein Nachteil der bisher eingesetzten Vielzahl an Teilentladungsmessungen ist damit, dass diese sehr kostenintensiv sind.

Da die Mittelspannungskabel eines Mittelspannungsnetzes nicht allesamt in einem kurzen Zeitraum wirtschaftlich teilentladungsgemessen werden können, ist es zudem möglich, dass aufgrund mangelnder Kapazitäten länger nicht teilentladungsgemessene Mittelspannungskabel zwischenzeitlich eine Beschädigung erfahren. Insoweit erlaubt das bisherige Verfahren mit den Teilentladungsmessungen aller Mittelspannungskabel, insbesondere derer, die eine Störung erfahren haben oder an denen gearbeitet worden ist, lediglich eine stückweite Reduzierung der Wahrscheinlichkeit einer Beschädigung. Ein weiterer Nachteil der bisher eingesetzten Vielzahl von Teilentladungsmessungen bzw. des Verfahrens zum Teilentladungsmessen von Mittelspannungskabeln eines Mittelspannungsnetzes ist damit die geringe Wirkung der zahlreichen Teilentladungsmessungen bezüglich möglicher Beschädigungen bzw. Störungen im Mittelspannungsnetz.

Aufgabe der Erfindung ist es, ein Verfahren zum Teilentladungsmessen von Mittelspannungskabeln eines Mittelspannungsnetzes vorzuschlagen, welches die aus dem Stand der Technik bekannten Nachteile, insbesondere die hohen Kosten und die geringe Wirkung, zumindest teilweise beseitigt.

WO 2020/209513 A1 offenbart ein Verfahren und System zum Teilentladungsmessen eines Spannungskabels.

Die voranstehende Aufgabe wird durch die Gegenstände der Patentansprüche, insbesondere durch ein Verfahren zum Teilentladungsmessen zumindest eines Mittelspannungskabels eines Mittelspannungsnetzes nach Anspruch 1, ein System nach Anspruch 12, ein Computerprogrammprodukt nach Anspruch 14 sowie ein computerlesbares Speichermedium nach Anspruch 15 gelöst. Weitere Vorteile und Details der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen System sowie umgekehrt, sodass bezüglich der Offenbarung zu den einzelnen Erfindungsaspekten stets wechselseitig Bezug genommen wird beziehungsweise werden kann.

Gemäß einem ersten Aspekt der Erfindung wird die eingangs genannte Aufgabe gelöst durch ein Verfahren zum Teilentladungsmessen zumindest eines Mittelspannungskabels eines Mittelspannungsnetzes. Das Verfahren weist die folgenden Schritte auf:
(a) Festlegen eines Grenzwerts für eine Störungswahrscheinlichkeit des zumindest einen Mittelspannungskabels,
(b) Bereitstellen von zumindest einem Parameter, welcher indikativ oder kausal für einen technischen Zustand des zumindest einen Mittelspannungskabels ist,
(c) Ermitteln einer Störungswahrscheinlichkeit des zumindest einen Mittelspannungskabels anhand des zumindest einen bereitgestellten Parameters, und
(d) Teilentladungsmessen des zumindest einen Mittelspannungskabels, sofern die ermittelte Störungswahrscheinlichkeit oberhalb des festgelegten Grenzwerts liegt.

Die Indikation der Verfahrensschritte mit der Auflistung (a) bis (d) dient lediglich der Strukturierung der Verfahrensschritte. Die Verfahrensschritte können, müssen aber nicht in der angegebenen Reihenfolge (a) bis (d) durchgeführt werden. Beispielsweise der Verfahrensschritt (a) kann alternativ nach dem Verfahrensschritt (b) und/oder nach dem Verfahrensschritt (c) durchgeführt werden.

Das Verfahren kann zumindest teilweise oder vollständig Computer-implementiert sein. Insbesondere ein, mehrere oder alle der Verfahrensschritte des Verfahrens können Computer-implementiert sein bzw. von einem Computer ausgeführt werden. Insbesondere können die Verfahrensschritte (a) bis (c) Computer-implementiert sein, wobei aber auch der Verfahrensschritt (d) zumindest teilweise Computer-implementiert sein kann. Unterschiedliche Computer eines Systems können zur Ausführung derartiger Computerimplementierter Verfahrensschritte eingerichtet sein. So können insbesondere die Verfahrensschritte (a) bis (c) auf einem anderen Computer ausgeführt werden als der Verfahrensschritt (d).

Das Verfahren kann zudem vorsehen, dass der Verfahrensschritt (d) in separate Teilschritte aufgeteilt ist. Dabei kann zuerst ermittelt werden, ob die ermittelte Störungswahrscheinlichkeit oberhalb des festgelegten Grenzwerts liegt. Sofern dies der Fall ist, kann das Teilentladungsmessen des zumindest einen Mittelspannungskabels als folgender Schritt ausgeführt werden. Möglich ist zudem ein Zwischenschritt einer Übertragung eines Signals bzw. Einsatzsignals zur Durchführung der Teilentladungsmessung. Der Zwischenschritt kann durchgeführt werden, nachdem ermittelt worden ist, dass die ermittelte Störungswahrscheinlichkeit oberhalb des festgelegten Grenzwerts liegt.

Das Verfahren hat den vorteilhaften Effekt, dass nur solche Mittelspannungskabel im Mittelspannungsnetz teilentladungsgemessen werden, bei denen von einer gemäß dem zuvor festgelegten Grenzwert erhöhten Störungswahrscheinlichkeit ausgegangen wird. Dies spart Kosten, da auf Basis der vorausgehenden technischen Zustandsevaluierung des Mittelspannungskabels gemäß des zumindest einen Parameters nicht jedes Mittelspannungskabel gemessen wird. Dadurch wird eine höhere Kapazität für Teilentladungsmessungen geschaffen, sodass mittels des Verfahrens gezielt die Mittelspannungskabel teilentladungsgemessen werden können, bei denen gemäß der technischen Zustandsevaluierung entsprechend der ermittelten Störungswahrscheinlichkeit von einem vergleichsweise schlechten Zustand ausgegangen wird.

Es kann vorgesehen sein, dass mehrere Parameter bereitgestellt werden und die Störungswahrscheinlichkeit unter Festlegung einer Gewichtung der mehreren bereitgestellten Parameter ermittelt wird. Unterschiedliche Parameter können insbesondere mittels eines Algorithmus gewichtet werden. Der Gewichtungswert kann beispielsweise ein Zahlenwert oder ein Funktionswert sein, der sich aus dem Algorithmus ergibt. Der aus den unterschiedlichen Parametern ermittelte Gewichtungswert kann dann für die Ermittlung der Störungswahrscheinlichkeit herangezogen werden. Die Gewichtung der Parameter kann dabei unterschiedlich erfolgen. Wenn beispielsweise unterschiedliche Parameter sich unterschiedlich auf den technischen Zustand der Mittelspannungskabel auswirken, können einzelne Parameter mit einer stärkeren Gewichtung und andere mit einer geringeren Gewichtung in den Gewichtungswert eingehen.

Ferner kann vorgesehen sein, dass mehrere Mittelspannungskabel teilentladungsgemessen werden, wobei die Reihenfolge der Teilentladungsmessungen der Mittelspannungskabel anhand der Störungswahrscheinlichkeit jedes Mittelspannungskabels festgelegt wird. Die Reihenfolge kann auch als Priorisierung bezeichnet werden. Die Reihenfolge oder Priorisierung kann entsprechend derart gestaltet werden, dass zunächst die Mittelspannungskabel oberhalb des festgelegten Grenzwerts teilentladungsgemessen werden, welche die höchste Störungswahrscheinlichkeit aufweisen und anschließend die Mittelspannungskabel mit der geringeren Störungswahrscheinlichkeit oberhalb des festgelegten Grenzwerts teilentladungsgemessen werden. Dadurch kann die Wahrscheinlichkeit, dass es zu einer Störung des Mittelspannungsnetzes in irgendeinem der Mittelspannungskabel kommt, insgesamt vergleichsweise schnell gesenkt werden. Der Grenzwert kann im Verlauf des Verfahrens auch verändert werden.

Zumeist bestehen Mittelspannungskabel zwischen zwei Netzstationen, auch Ortsnetzstationen genannt, aus verschiedenen Teilstücken. Dies rührt daher, dass das Ersetzen eines defekten oder alten Teils des Mittelspannungskabels aufgrund der damit verbundenen hohen Kosten zumeist nur stückartig erfolgt. Entsprechend sind die meisten Mittelspannungskabel im Mittelspannungsnetz aus unterschiedlichen Teilstücken eines Mittelspannungskabels zusammengesetzt. Diese Teilstücke können jeweils einen unterschiedlichen Anteil an der Gesamtlänge des Mittelspannungskabels haben bzw. unterschiedliche Längen aufweisen. Sie können neben den unterschiedlichen Längen auch unterschiedliche Bauarten, Materialen und/oder Alter aufweisen. Zudem können unterschiedliche Arten von Verbindungskomponenten zwischen den Teilstücken des Mittelspannungskabels angeordnet werden, welche die Teilstücke elektrisch miteinander verbinden. Die Verbindungskomponenten können insbesondere als Muffen ausgebildet sein.

Es kann vorgesehen sein, dass der zumindest eine Parameter das zumindest eine Mittelspannungskabel, insbesondere eine Bauart, ein Material, ein Alter und/oder eine Länge eines Teilstücks des zumindest einen Mittelspannungskabels, betrifft. Entsprechend kann bei mehreren Parametern wenigstens ein Parameter einer der vorgenannten sein oder mehrere Parameter können unterschiedliche der vorgenannten sein. Derartige technische Parameter des Mittelspannungskabels, wobei diese auch nur Teilstücke des Mittelspannungskabels betreffen können, haben sich als geeignete Parameter für die Indikation des technischen Zustands des Mittelspannungskabels und damit für die Ermittlung der Störungswahrscheinlichkeit gezeigt. So sind beispielsweise verschiedene Bauarten von Mittelspannungskabeln bekannt, etwa Massekabel, die einen vergleichsweise schlechten technischen Zustand aufgrund der vergleichsweise störungsanfälligen Technologie aufweisen. Kunststoffkabel, insbesondere neuerer Generation, sind hingegen in ihrer Bauart von Mittelspannungskabeln typischerweise in einem guten technischen Zustand und daher weniger störungsanfällig. Ein hohes Alter der Mittelspannungskabel kann zudem genauso wie eine geringe Länge des Mittelspannungskabels oder eines Teilstücks davon, insbesondere in Kombination mit bestimmten Bauarten wie dem Massekabel, für einen schlechten technischen Zustand sorgen und somit für eine höhere Störungsanfälligkeit und damit Störungswahrscheinlichkeit sorgen.

Alternativ oder zusätzlich kann vorgesehen sein, dass der zumindest eine Parameter zumindest eine Verbindungskomponente von Teilstücken des Mittelspannungskabels, insbesondere eine Bauart, ein Material und/oder ein Alter der zumindest einen Verbindungskomponente, betrifft. Entsprechend kann bei mehreren Parametern wenigstens ein Parameter einer der vorgenannten sein oder mehrere Parameter können unterschiedliche der vorgenannten sein. Auch bezüglich dieser technischen Parameter hat sich gezeigt, dass diese eine geringere oder höhere Störungsanfälligkeit und damit Störungswahrscheinlichkeit bedingen können.

Ferner alternativ oder zusätzlich kann vorgesehen sein, dass der zumindest eine Parameter empirisch auf zuvor festgestellten Störungen von dem zumindest einen Mittelspannungskabel und/oder auf zuvor festgestellten Zuständen von dem zumindest einen Mittelspannungskabel basiert ist. Entsprechend kann bei mehreren Parametern wenigstens ein Parameter einer der vorgenannten sein oder mehrere Parameter können unterschiedliche der vorgenannten sein. Für die zuvor festgestellten Störungen kann eine Häufigkeit und/oder Art der Störung empirisch ausgewertet und einem bestimmten Zeithorizont zugeordnet werden, wodurch sich ein für den technischen Zustand indikativer Parameter bilden lässt, der für die Ermittlung der Störungswahrscheinlichkeit genutzt werden kann. Die zuvor festgestellten Zustände lassen sich beispielsweise durch vorherige Teilentladungsmessungen ermitteln, welche die Zustände abbilden.

Schließlich kann alternativ oder zusätzlich vorgesehen sein, dass der zumindest eine Parameter zumindest einen Bodentyp, in welchen das zumindest eine Mittelspannungskabel eingebettet ist, und/oder eine Infrastrukturumgebung, unter welcher sich das zumindest eine Mittelspannungskabel befindet, betrifft. So konnte festgestellt werden, dass der technische Zustand mit dem Bodentyp korrelieren kann und zudem auch die umliegende bzw. umgebende Infrastruktur Auswirkungen auf den technischen Zustand, insbesondere das Verschleißen der Isolierungen der Mittelspannungskabel, haben kann. So können beispielsweise über dem Mittelspannungskabel befindliche Straßenbahngleise oder Hauptverkehrsstraßen für Erosionen und Erschütterungen sorgen, welche den technischen Zustand verschlechtern und die Störungswahrscheinlichkeit erhöhen können.

Außerdem kann vorgesehen sein, dass das Teilentladungsmessen durch einen Kabelmesswagen durchgeführt wird. Es kann vorgesehen werden, dass der Kabelmesswagen für das Teilentladungsmessen zu einer Netzstation des zumindest einen Mittelspannungskabels gefahren wird. Das Verfahren kann entsprechend den Schritt des Fahrens und/oder Navigierens des Kabelmesswagens zur Netzstation als Einsatzort für das Teilentladungsmessen umfassen. Dieser Schritt kann vor dem Teilentladungsmessen ausgeführt werden. Er kann ebenfalls oder statt des Teilentladungsmessens davon abhängig gemacht werden, ob die ermittelte Störungswahrscheinlichkeit unterhalb des festgelegten Grenzwerts liegt. Dann kann mittels des Verfahrens bereits das Anfahren mit dem Kabelmesswagen gesteuert werden, sodass das Anfahren des Kabelmesswagens vermieden werden kann, wenn keine Teilentladungsmessung an einem Mittelspannungskabel durchgeführt werden soll. Dies ist beispielsweise dann vorteilhaft, wenn nicht nach einer Spannungsprüfung eine zusätzliche Teilentladungsmessung durchgeführt werden soll, bei der der Kabelmesswagen sich bereits an der zugehörigen Netzstation befindet, sondern eine separate Teilentladungsmessung durchgeführt werden soll.

Im Übrigen kann vorgesehen sein, dass eine Empfangseinheit des Kabelmesswagens ein Einsatzsignal für das Teilentladungsmessen empfängt, sofern die bestimmte Störungswahrscheinlichkeit des zumindest einen Mittelspannungskabels oberhalb des festgelegten Grenzwerts liegt. Die Empfangseinheit kann Teil des Kabelmesswagens sein, also damit verbaut sein, oder aber eine von dem Kabelmesswagen separate Empfangseinheit sein, die damit in Verbindung, insbesondere in drahtloser Verbindung, steht oder zumindest dazu eingerichtet ist, mit dem Kabelmesswagen verbunden zu werden. Eine separate Empfangseinheit kann beispielsweise ein Smartphone, Tablet oder Notebook sein.

Auch kann vorgesehen sein, dass das Einsatzsignal eine Information über eine Netzstation des zumindest einen Mittelspannungskabels enthält. Die Information über die Netzstation kann beispielsweise in Form einer Adresse, geographischer Koordinaten, einer Bezeichnung und/oder Statusinformationen der Netzstation beschaffen sein. Entsprechend können diese Informationen über die Empfangseinheit empfangen werden. Die Empfangseinheit kann ein Anzeigemittel zur Anzeige dieser Informationen umfassen oder dazu eingerichtet sein, die Informationen auf einem Anzeigemittel des Kabelmesswagens anzuzeigen. Die Adresse oder geographischen Koordinaten können in einem Navigationssystem der Empfangseinheit oder des Kabelmesswagens zur Navigation zur Netzstation verwendet werden. Der Kabelmesswagen kann zudem ein autonomes Kraftfahrzeug sein. Entsprechend kann vorgesehen sein, dass der Kabelmesswagen autonom zur Netzstation fährt, wenn das Einsatzsignal empfangen wird. Dadurch kann ein sehr hoher Grad an Automatisierung erzielt werden, der sich vorteilhaft auf die Kosten des Verfahrens auswirkt.

Es kann außerdem vorgesehen sein, dass zumindest eine Drohne Bilder von Netzstationen an jeweiligen Enden des zumindest einen Mittelspannungskabels aufnimmt und anhand der Bilder eine der beiden Netzstationen als Netzstation für das Teilentladungsmessen festgelegt wird. Grundsätzlich kann ein Mittelspannungskabel an seinen beiden Enden, an denen sich jeweils eine Netzstation des Mittelspannungsnetzes befindet, teilentladungsgemessen werden. Grundsätzlich benötigt der Kabelmesswagen einen hinreichend großen Platz bzw. Raum in unmittelbarer Nähe der Netzstation. Abhängig von den aktuellen Gegebenheiten kann es jedoch durchaus vorkommen, dass der Zugang zur Netzstation durch andere Fahrzeuge oder andere Objekte versperrt oder behindert wird. Um von vornherein die besser zugängliche Netzstation zu identifizieren und damit die Teilentladungsmessung schneller und kostengünstiger durchführen zu können, wird die entsprechende zumindest eine Drohne eingesetzt. Anhand der Bilder oder Aufnahmen einer entsprechenden Kameraeinheit der zumindest einen Drohne lässt sich analysieren, wie der Zugang zur jeweiligen der zwei Netzstationen eines Mittelspannungskabels ist. Dies kann insbesondere mittels eines entsprechenden Bildanalysealgorithmus erfolgen. Das Ergebnis der Analyse ist eine Empfehlung einer der beiden Netzstationen. Entsprechend kann diese auch in dem Einsatzsignal als Information enthalten sein.

Ferner kann vorgesehen sein, dass die zumindest eine Drohne zudem Bilder entlang dem Erdboden, insbesondere einer Straße, unterhalb derer das zumindest eine Mittelspannungskabels verläuft, aufnimmt. Diese Bilder können vorteilhafterweise für eine Störungsanalyse bei einer möglichen späteren oder früheren Störung verwendet werden. Zwar ist das Mittelspannungskabel selbst nicht sichtbar, allerdings erlauben die Bilder eine Analyse dessen, welche Gegebenheiten auf dem Erdboden bzw. der Straße über dem Mittelspannungskabel herrschen, welches die Störung verursacht hat. Auch hierzu kann ein entsprechender Bildanalysealgorithmus eingesetzt werden. Vorteilhafterweise lassen sich die aufgenommenen Bilder zudem für eine spätere Straßenerneuerung nutzen, die beispielsweise dann erforderlich werden kann, wenn die Teilentladungsmessung des Mittelspannungskabels eine solche als erforderlich erscheinen lässt.

Gemäß einem zweiten Aspekt der Erfindung wird die eingangs erwähnte Aufgabe gelöst durch ein System umfassend eine Messvorrichtung zur Durchführung einer Teilentladungsmessung und einen Computer, wobei das System zum Durchführen des Verfahrens nach dem ersten Aspekt der Erfindung eingerichtet ist.

Es kann vorgesehen sein, dass das System ferner den bereits zuvor erläuterten Kabelmesswagen aufweist, welcher zumindest die Messvorrichtung umfasst. Der Kabelmesswagen kann zudem auch den Computer umfassen bzw. das System in seiner Gesamtheit bilden.

Der Computer kann Teil der Messvorrichtung sein oder die Messvorrichtung kann ihrerseits Teil des Computers sein. Diese Messvorrichtung kann ein Computer sein oder einen weiteren Computer aufweisen.

Das System kann, wie erwähnt, beispielsweise der Kabelmesswagen, insbesondere mit den zuvor bereits beschriebenen Merkmalen, sein. Der Kabelmesswagen kann den Computer aufweisen, welcher seinerseits zumindest die Verfahrensschritte (a) bis (c) ausführt. Er kann zudem die Messvorrichtung aufweisen, welche den Verfahrensschritt (d) ausführt. Der Computer kann zur Ausführung des Verfahrensschritts (d) ferner die Schritte eines Ermittelns, ob die ermittelte Störungswahrscheinlichkeit oberhalb des festgelegten Grenzwerts liegt und des Übertragens eines Signals, insbesondere des zuvor beschriebenen Einsatzsignals, an die Messvorrichtung zum Durchführen des Verfahrensschritts (d) aufweisen.

Es ist alternativ aber auch möglich, dass es sich bei der Messvorrichtung und dem Computer um voneinander separate Komponenten in dem System handelt. Die Messvorrichtung und der Computer können örtlich voneinander getrennt sein. Die Messvorrichtung und der Computer können aber insbesondere drahtlos miteinander verbunden sein, insbesondere über eine Mobilfunktechnologie.

Beispielsweise ist es möglich, dass der Computer in dem System örtlich von der Messvorrichtung distanziert ist. Der Kabelmesswagen kann dabei ebenfalls die Messvorrichtung umfassen. Entsprechend kann das System den Kabelmesswagen mit zumindest der Messvorrichtung und/oder dem Computer umfassen. In diesem Fall kann der Computer ebenfalls die Verfahrensschritte (a) bis (c) ausführen, dies jedoch örtlich getrennt von dem Kabelmesswagen. Die Messvorrichtung bzw. der Kabelmesswagen kann dann den Verfahrensschritt (d) ausführen. Der Computer kann zur Ausführung des Verfahrensschritts (d) ferner die Schritte eines Ermittelns, ob die ermittelte Störungswahrscheinlichkeit oberhalb des festgelegten Grenzwerts liegt und des Übertragens eines Signals, insbesondere des zuvor beschriebenen Einsatzsignals, an die Messvorrichtung bzw. den Kabelmesswagen, insbesondere eine drahtlose Empfangseinheit des Kabelmesswagens, zum Durchführen des Verfahrensschritts (d) aufweisen. Die Übertragung des Signals kann mittels der Mobilfunktechnologie bzw. eines Mobilfunknetzes erfolgen.

Das System kann ferner die zuvor beschriebene zumindest eine Drohne umfassen. Die zumindest eine Drohne kann zur Ausführung der zuvor bereits erläuterten Funktionalität eingerichtet sein. Die zumindest eine Drohne kann beispielsweise Teil des Kabelmesswagens sein bzw. von ihm aufgenommen und/oder von ihm aus gesteuert werden.

Gemäß einem dritten Aspekt der Erfindung wird die eingangs erwähnte Aufgabe gelöst durch ein Computerprogrammprodukt, umfassend Befehle, die bewirken, dass das System gemäß dem zweiten Aspekt der Erfindung das Verfahren gemäß dem ersten Aspekt der Erfindung ausführt.

Gemäß einem vierten Aspekt der Erfindung wird die eingangs erwähnte Aufgabe gelöst durch ein computerlesbares Speichermedium, auf dem das Computerprogrammprodukt nach dem dritten Aspekt der Erfindung gespeichert ist. Bei dem computerlesbaren Speichermedium kann es sich beispielsweise um einen Speicher in dem Computer des Systems handeln.

Anhand der beigefügten Zeichnung wird die Erfindung gemäß von Ausführungsbeispielen nachfolgend näher erläutert. Sämtliche aus den Ansprüchen, der Beschreibung oder der Figur hervorgehenden Merkmale, einschließlich konstruktiver Einzelheiten, können sowohl für sich als auch in den beliebigen verschiedenen Kombinationen erfindungswesentlich sein. Es zeigen:
- Fig. 1: eine schematische Darstellung eines Ausschnitts eines Mittelspannungsnetzes;
- Fig. 2: eine schematische Darstellung eines Systems zum Durchführen eines Verfahrens zum Teilentladungsmessen eines Mittelspannungskabels in dem Mittelspannungsnetz aus Fig. 1 und gemäß Fig. 3; und
- Fig. 3: eine schematische Darstellung eines Verfahrens zum Teilentladungsmessen mittels des Systems aus Fig. 2.

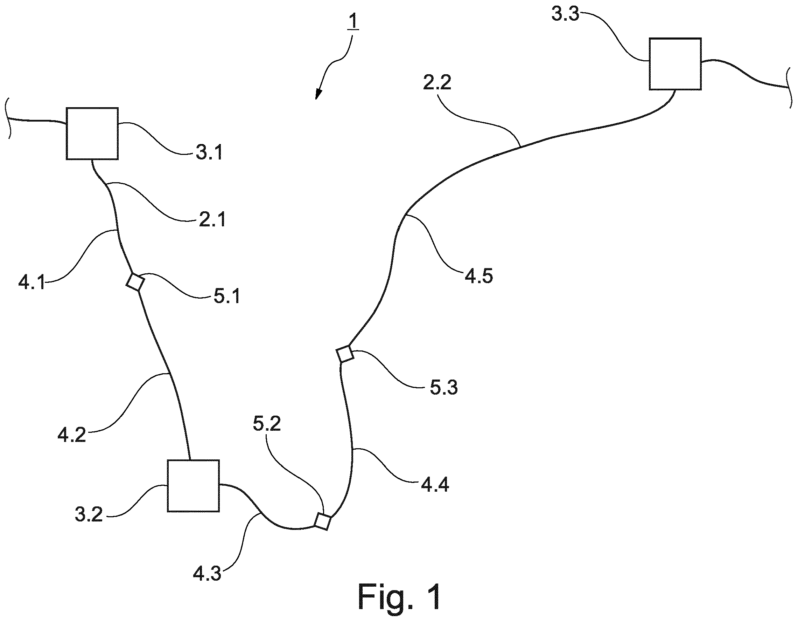

Elemente mit gleicher Funktion und Wirkungsweise sind in den Figuren 1 bis 3 jeweils mit denselben Bezugszeichen versehen. Soweit ein Element häufiger als einmal in einer der Figuren vorhanden ist, wird dasselbe Bezugszeichen verwendet, wobei die Bezugszeichen zur Unterscheidung der Elemente voneinander fortlaufend nummeriert werden und die fortlaufende Nummerierung durch einen Punkt von dem Bezugszeichen getrennt ist.

Figur 1 zeigt einen Ausschnitt eines Mittelspannungsnetzes 1, welches mit seinen Mittelspannungskabeln 2.1, 2.2 unterirdisch verläuft. Beispielhaft zeigt der Ausschnitt des Mittelspannungsnetzes 1 vorliegend lediglich zwei Mittelspannungskabel 2.1, 2.2, obgleich selbstverständlich das Mittelspannungsnetz 1 tatsächlich eine um ein Vielfaches höhere Anzahl von Mittelspannungskabeln 2.1, 2.2 aufweist. Dies wird an den Netzstationen 3.1, 3.3 durch weitere, nicht bezeichnete Mittelspannungskabel angedeutet, die von diesen abgehen.

Die Mittelspannungskabel 2.1, 2.2 sind vorliegend mit ihren Enden an Netzstationen 3.1, 3.2, 3.3 des Mittelspannungsnetzes 1 angeschlossen. Die Mittelspannungskabel 2.1, 2.2 weisen eine Anzahl von Teilstücken 4.1, 4.2, 4.3, 4.4, 4.5 auf, aus denen sie zusammengesetzt sind. Die Teilstücke 4.1, 4.2, 4.3, 4.4, 4.5 sind jeweils durch Verbindungskomponenten 5.1, 5.2, 5.3 in Form von Muffen miteinander verbunden.

Das Mittelspannungsnetz 1 wird von einem Betreiber in Stand gehalten. Die Mittelspannungskabel 2.1, 2.2 können beispielsweise aufgrund ihrer technischen Gegebenheiten und/oder Umgebung unterschiedlich störanfällig sein. Insbesondere ist für jedes der beiden Mittelspannungskabel 2.1, 2.2 ein gewisser technischer Zustand, eine damit zusammenhängende gewisse Störanfälligkeit und damit im Zusammenhang stehende Störungswahrscheinlichkeit gegeben. Diese kann von verschiedenen Parametern abhängig sein bzw. können verschiedene Parameter indikativ für den technischen Zustand und damit für die Störungswahrscheinlichkeit der Mittelspannungskabel 2.1, 2.2 sein. Die Identifizierung der Parameter und ihre Analyse ermöglicht eine Berechnung der Störungswahrscheinlichkeit der Mittelspannungskabel 2.1, 2.2.

Diese Parameter können beispielsweise die Mittelspannungskabel 2.1, 2.2 betreffen. Insbesondere können solche Parameter eine Bauart, eine Länge eines Teilstücks, eine Anzahl von Teilstücken, ein Material und/oder ein Alter betreffen. Ferner können diese Parameter auch die Verbindungskomponenten 5.1, 5.2, 5.3 betreffen, welche beispielsweise eine Bauart, ein Material, eine Anzahl und/oder ein Alter betreffen.

Weiterhin können die Parameter den Bodentyp, in den die Mittelspannungskabel 2.1, 2.2 eingebettet sind und/oder eine Infrastrukturumgebung, unter welcher sich die unterirdischen Mittelspannungskabel 2.1, 2.2 befinden, betreffen. Auch empirisch zuvor festgestellte Störungen der Mittelspannungskabel 2.1, 2.2 und/oder zuvor festgestellten Zustände der Mittelspannungskabel 2.1, 2.2 können als Parameter herangezogen werden.

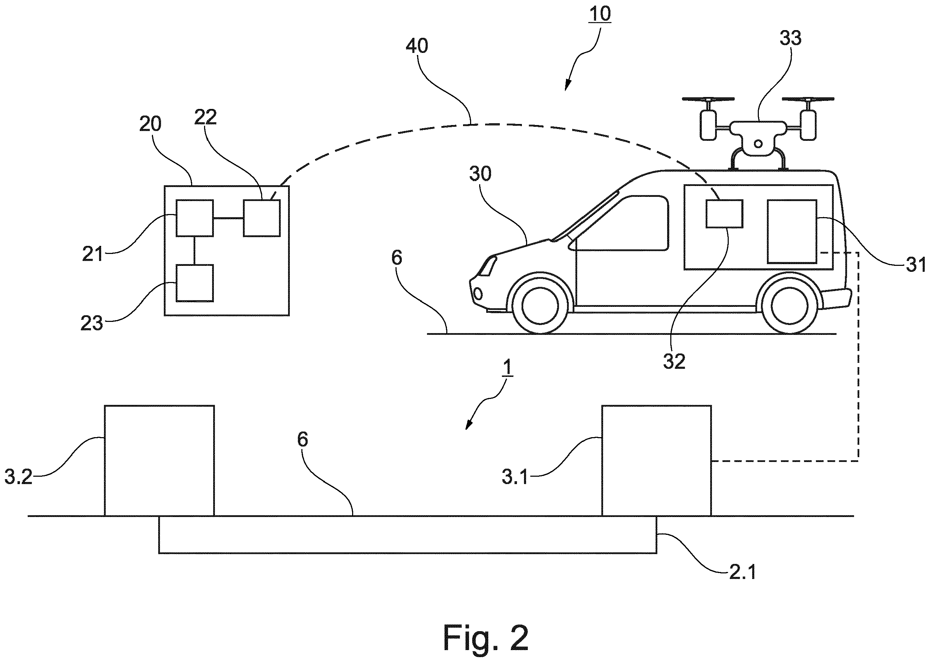

Figur 2 zeigt ein System 10 zum Durchführen eines Verfahrens 100 zum Teilentladungsmessen eines der Mittelspannungskabel 2.1, 2.2 in dem Mittelspannungsnetz 1 aus Fig. 1.

Das System 10 umfasst einen Computer 20 und eine Messvorrichtung 31 zum Teilentladungsmessen der Mittelspannungskabel 2.1, 2.2 an den Netzstationen 3.1, 3.2, 3.3. Die Messvorrichtung 31 ist vorliegend Teil eines Kabelmesswagens 30, der ebenfalls Teil des Systems 10 ist und vorliegend auf einem Erdboden 6 steht, unter dem auch die Mittelspannungskabel 2.1, 2.2 verlaufen. Die Messvorrichtung 31 kann ebenfalls einen Computer 20 umfassen. Alternativ ist möglich, dass der Computer 20 Bestandteil des Kabelmesswagens 30 oder der Messvorrichtung 31 ist. Vorliegend sind der Computer 20 und die Messvorrichtung 31 allerdings örtlich voneinander getrennte bzw. trennbare Komponenten.

Der Computer 20 umfasst eine Recheneinheit 21, eine drahtlose Sendeeinheit 22 und eine Speichereinheit bzw. ein Speichermedium 23. In dem Speichermedium 23 sind die Parameter gespeichert, die für den technischen Zustand der Mittelspannungskabel 2.1, 2.2 indikativ sind bzw. den technischen Zustand bestimmen.

Der Kabelmesswagen 30 umfasst neben der Messvorrichtung 31 eine drahtlose Empfangseinheit 32. Die drahtlose Empfangseinheit 32 kann von der drahtlosen Sendeeinheit 22 ein Einsatzsignal empfangen. Das Einsatzsignal wird über eine drahtlose Kommunikationsverbindung 40 übertragen, die beispielswiese auf einer Mobilfunktechnologie basieren kann. Außerdem umfasst der Kabelmesswagen 30 eine Drohne 33.

Beispielhaft ist zudem in der Fig. 2 ein Ausschnitt des Mittelspannungsnetzes 1 mit dem Mittelspannungskabel 2.1 gezeigt. Das Mittelspannungskabel 2.1 befindet sich zwischen den Netzstationen 3.1, 3.2. Die Messvorrichtung 31 ist vorliegend mit der Netzstation 3.1 zum Teilentladungsmessen des Mittelspannungskabels 2.1 verbunden.

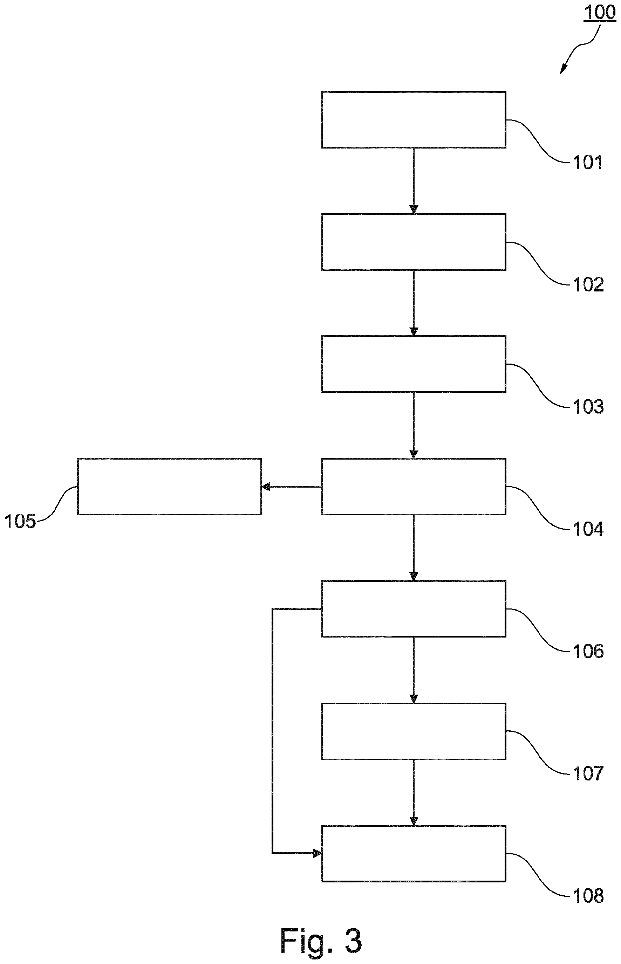

Figur 3 zeigt schematisch das bereits erwähnte Verfahren 100 zum Teilentladungsmessen eines der Mittelspannungskabel 2.1, 2.2 in dem Mittelspannungsnetz 1, etwa des Mittelspannungskabels 2.1, wie es in Fig. 2 gezeigt ist.

In einem ersten Verfahrensschritt 101 wird durch den Computer 20, insbesondere die Recheneinheit 21, ein Grenzwert für eine Störungswahrscheinlichkeit der Mittelspannungskabel 2.1, 2.2 des Mittelspannungsnetzes 1 festgelegt. Dieser Grenzwert kann durch einen entsprechenden Algorithmus auf Basis einer Anzahl von Mittelspannungskabeln 2.1, 2.2 ermittelt werden, die teilentladungsgemessen werden müssen bzw. sollen. Dabei können Faktoren wie Verfügbarkeit von Kabelmesswagen 30 berücksichtigt werden. Eine Vorgabe für die Festlegung des Grenzwerts kann aber auch manuell durch einen Nutzer des Computers 20 erfolgen.

In einem auf den ersten Verfahrensschritt 101 folgenden zweiten Verfahrensschritt 102 werden unterschiedliche Parameter, welche indikativ für einen technischen Zustand der Mittelspannungskabel 2.1, 2.2 sind, wie vorstehend erläutert worden ist, aus dem Speicher 23 an der Recheneinheit 21 bereitgestellt.

Die Recheneinheit 21 ermittelt in einem darauf folgenden dritten Verfahrensschritt 103 auf Basis eines Algorithmus, der in der Speichereinheit 23 abgespeichert sein kann, eine Störungswahrscheinlichkeit der Mittelspannungskabel 2.1, 2.2 anhand der Parameter.

In einem darauf folgenden vierten Verfahrensschritt 104 wird von der Recheneinheit 21 ermittelt, ob die ermittelten Störungswahrscheinlichkeiten der Mittelspannungskabel 2.1, 2.2 jeweils oberhalb des zuvor festgelegten Grenzwertes liegen. Sofern dies für eines oder beide der Mittelspannungskabel 2.1, 2.2 nicht der Fall ist, der Grenzwert also durch die ermittelte(n) Störungswahrscheinlichkeit(en) unterschritten wird, wird das Verfahren 100 in einem fünften Verfahrensschritt 105 terminiert. Ursache hierfür ist die gemäß dem Grenzwert durch die Recheneinheit 21 anhand des Algorithmus getroffene Annahme, dass das oder die Mittelspannungskabel 2.1, 2.2 eine geringe Störungswahrscheinlichkeit aufweisen und eine Teilentladungsmessung in Anbetracht der damit verbundenen Kosten nicht erforderlich ist. Stattdessen kann der Kabelmesswagen 30 für andere Mittelspannungskabel 2.1, 2.2 des Mittelspannungsnetzes 1 genutzt werden, die einen schlechteren technischen Zustand und eine höhere Störungswahrscheinlichkeit aufweisen.

Sofern also ein solches Mittelspannungskabel 2.1, 2.2 mit einem schlechteren technischen Zustand bzw. höheren Störungswahrscheinlichkeit ermittelt wird bzw. der Grenzwert durch die ermittelte(n) Störungswahrscheinlichkeit(en) überschritten wird, wird das Verfahren 100 in einem sechsten Verfahrensschritt 106 fortgesetzt.

In dem sechsten Verfahrensschritt 106 wird von der Recheneinheit 21 ein Einsatzsignal erzeugt, welches von der drahtlosen Sendeeinheit 22 mittels der drahtlosen Kommunikationsverbindung 40 an die drahtlose Empfangseinheit 32 des Kabelmesswagens 30 übertragen wird. Das Einsatzsignal enthält die Information, dass ein Teilentladungsmessen des jeweiligen Mittelspannungskabels 2.1, 2.2, beispielsweise des Mittelspannungskabels 2.1, wie es in Fig. 2 gezeigt ist, erfolgen soll, weil es eine Störungswahrscheinlichkeit aufweist, die oberhalb des festgelegten Grenzwerts liegt. Das Einsatzsignal kann auch andere Informationen enthalten, die für die Fahrt des Kabelmesswagens 30 zu einer der Netzstationen 3.1, 3.2 des betreffenden Mittelspannungskabels 2.1 relevant sind, etwa geographische Koordinaten.

In einem siebten Verfahrensschritt 107 kann der Kabelmesswagen 30 entsprechend zur Netzstation 3.1, wie es in Fig. 2 gezeigt ist, fahren. Der Kabelmesswagen 30 kann dabei ein autonomes Fahrzeug sein, das autonom zur Netzstation 3.1 fährt. Ferner kann vorgesehen sein, dass die Drohne 33 zuvor oder parallel Bilder von der Umgebung der Netzstationen 3.1, 3.2 aufnimmt und diese an die Recheneinheit 21 übermittelt. Die Recheneinheit 21 kann die Bilder analysieren und die geographischen Koordinaten derjenigen Netzstation 3.1, 3.2 im Rahmen des Einsatzsignals oder eines weiteren Einsatzsignals an den Kabelmesswagen 30 übertragen, welche für die Kabelmesswagen 30 anhand der aus den Bildern analysierten Informationen besser zugänglich sein sollte.

Wenn der Kabelmesswagen 30 bereits aufgrund etwa einer vorherigen Spannungsprüfung nach einer Störung oder Arbeiten am Mittelspannungskabel 2.1 bereits vor Ort bzw. an der Netzstation 3.1 ist, kann der siebte Verfahrensschritt 107 auch übersprungen werden, wie durch den weiteren Pfad von dem sechsten Verfahrensschritt 106 zum achten und letzten Verfahrensschritt 108 gezeigt ist. Auch sonst kann der siebte Verfahrensschritt 107 nicht von den vorherigen Verfahrensschritten 100 bis 106 des Verfahrens 100 abhängig gemacht werden, sondern gleich zum achten Verfahrensschritt 108 übergegangen werden.

In dem achten Verfahrensschritt 108 wird schließlich das Mittelspannungskabel 2.1 teilentladungsgemessen.

Das Verfahren 100 kann von einem Computerprogrammprodukt mit Befehlen (nicht gezeigt) umfasst sein, die bei der Ausführung durch den Computer 20 bzw. die Recheneinheit 21 das System 10 dazu veranlassen, das Verfahren 100 auszuführen. Das Computerprogrammprodukt kann auf einem Speichermedium, insbesondere der Speichereinheit 23 gespeichert sein.

Die Ergebnisse der Teilentladungsmessung des Mittelspannungskabels 2.1 können wiederum in einem weiteren Schritt (nicht gezeigt) auf den Computer 20 übertragen werden. Dazu kann die drahtlose Empfangseinheit 32 auch eine Sendefunktion haben bzw. allgemein als Kommunikationseinheit eingerichtet sein und auch die drahtlose Sendeinheit 22 kann entsprechend eine Empfangsfunktion haben bzw. allgemein als Kommunikationseinheit eingerichtet sein. Diese Ergebnisse können in der Speichereinheit 23 abgespeichert werden und beispielsweise als neue Parameter abgelegt werden oder für eine ggf. notwendige Erneuerung des Mittelspannungskabels 2.1 genutzt werden. Dadurch kann das Verfahren laufend optimiert werden.

### Bezugszeichenliste

- 1: Mittelspannungsnetz
- 2.1, 2.2: Mittelspannungskabel
- 3.1, 3.2, 3.3: Netzstation
- 4.1...4.5: Teilstück
- 5.1, 5.2, 5.3: Verbindungskomponente
- 6: Erdboden
- 10: System
- 20: Computer
- 21: Recheneinheit
- 22: Sendeeinheit
- 23: Speichereinheit, Speichermedium
- 30: Kabelmesswagen
- 31: Messvorrichtung
- 32: Empfangseinheit
- 33: Drohne
- 40: Kommunikationsverbindung
- 100: Verfahren
- 101... 108: Verfahrensschritte

## Patentansprüche

1. Verfahren (100) zum Teilentladungsmessen zumindest eines Mittelspannungskabels (2.1, 2.2) eines Mittelspannungsnetzes (1), wobei das Verfahren die folgenden Schritte aufweist:
(a) Festlegen eines Grenzwerts für eine Störungswahrscheinlichkeit des zumindest einen Mittelspannungskabels (2.1, 2.2),
(b) Bereitstellen von zumindest einem Parameter, welcher indikativ für einen technischen Zustand des zumindest einen Mittelspannungskabels (2.1, 2.2) ist,
(c) Ermitteln einer Störungswahrscheinlichkeit des zumindest einen Mittelspannungskabels (2.1, 2.2) anhand des zumindest einen bereitgestellten Parameters, und
(d) Teilentladungsmessen des zumindest einen Mittelspannungskabels (2.1, 2.2), sofern die ermittelte Störungswahrscheinlichkeit oberhalb des festgelegten Grenzwerts liegt.

2. Verfahren (100) nach Anspruch 1, wobei mehrere Parameter bereitgestellt werden und die Störungswahrscheinlichkeit unter Festlegung einer Gewichtung der mehreren bereitgestellten Parameter ermittelt wird.

3. Verfahren (100) nach Anspruch 1 oder 2, wobei mehrere Mittelspannungskabel (2.1, 2.2) teilentladungsgemessen werden, wobei die Reihenfolge der Teilentladungsmessungen der Mittelspannungskabel (2.1, 2.2) anhand der Störungswahrscheinlichkeit jedes Mittelspannungskabels (2.1, 2.2) festgelegt wird, und/oder
wobei der zumindest eine Parameter das zumindest eine Mittelspannungskabel (2.1, 2.2), insbesondere eine Bauart, ein Material, ein Alter und/oder eine Länge eines Teilstücks (4.1, 4.2, 4.3, 4.4, 4.5) des zumindest einen Mittelspannungskabels (2.1, 2.2), betrifft.

4. Verfahren (100) nach einem der voranstehenden Ansprüche, wobei der zumindest eine Parameter zumindest eine Verbindungskomponente (5.1, 5.2, 5.3) von Teilstücken (4.1, 4.2, 4.3, 4.4. 4.5) des Mittelspannungskabels (2.1, 2.2), insbesondere eine Bauart, ein Material und/oder ein Alter der zumindest einen Verbindungskomponente (5.1, 5.2, 5.3), betrifft.

5. Verfahren (100) nach einem der voranstehenden Ansprüche, wobei der zumindest eine Parameter empirisch auf zuvor festgestellten Störungen von dem zumindest einen Mittelspannungskabel (2.1, 2.2) und/oder auf zuvor festgestellten Zuständen von dem zumindest einen Mittelspannungskabel (2.1, 2.2) basiert.

6. Verfahren (100) nach einem der voranstehenden Ansprüche, wobei der zumindest eine Parameter zumindest einen Bodentyp, in welchen das zumindest eine Mittelspannungskabel (2.1, 2.2) eingebettet ist, und/oder eine Infrastrukturumgebung, unter welcher sich das zumindest eine Mittelspannungskabel (2.1, 2.2) befindet, betrifft.

7. Verfahren (100) nach einem der voranstehenden Ansprüche, wobei das Teilentladungsmessen durch einen Kabelmesswagen (30) durchgeführt wird, der insbesondere für das Teilentladungsmessen zu einer Netzstation (3.1, 3.2, 3.3) des zumindest einen Mittelspannungskabels (2.1, 2.2) gefahren wird.

8. Verfahren (100) nach Anspruch 7, wobei eine Empfangseinheit (32) des Kabelmesswagens (30) ein Einsatzsignal für das Teilentladungsmessen empfängt, sofern die bestimmte Störungswahrscheinlichkeit des zumindest einen Mittelspannungskabels (2.1, 2.2) oberhalb des festgelegten Grenzwerts liegt.

9. Verfahren (100) nach Anspruch 8, wobei das Einsatzsignal eine Information über eine Netzstation (3.1, 3.2, 3.3) des zumindest einen Mittelspannungskabels (2.1, 2.2) enthält, insbesondere
wobei die Information eine Adresse, geographische Koordinaten, eine Bezeichnung und/oder Statusinformationen der Netzstation (3.1, 3.2, 3.3) enthalten.

10. Verfahren (100) nach einem der Ansprüche 7 bis 9, wobei zumindest eine Drohne (33) Bilder von Netzstationen (3.1, 3.2, 3.3) an jeweiligen Enden des zumindest einen Mittelspannungskabels (2.1, 2.2) aufnimmt und anhand der Bilder eine der beiden Netzstationen (3.1, 3.2, 3.3) als Netzstation (3.1, 3.2, 3.3) für das Teilentladungsmessen festgelegt wird.

11. Verfahren (100) nach Anspruch 10, wobei die zumindest eine Drohne (33) zudem Bilder entlang dem Erdboden (6), insbesondere einer Straße, unterhalb derer das zumindest eine Mittelspannungskabels (3.1, 3.2, 3.3) verläuft, aufnimmt.

12. System (10) umfassend eine Messvorrichtung (31) zur Durchführung einer Teilentladungsmessung und einen Computer (20), wobei das System (10) zum Durchführen des Verfahrens (100) nach einem der voranstehenden Ansprüche eingerichtet ist.

13. System (10) nach Anspruch 12, wobei das System (10) einen Kabelmesswagen (30) aufweist, welcher zumindest die Messvorrichtung (31) umfasst.

14. Computerprogrammprodukt, umfassend Befehle, die bewirken, dass das System (10) des Anspruchs 12 oder 13 das Verfahren (100) nach einem der Ansprüche 1 bis 11 ausführt.

15. Computerlesbares Speichermedium (23), auf dem das Computerprogrammprodukt nach Anspruch 14 gespeichert ist.

## Claims

1. A method (100) for partial discharge measurement of at least one medium voltage cable (2.1, 2.2) of a medium voltage network (1), the method comprising the following steps:
(a) Determining a limit value for a fault probability of the at least one medium voltage cable (2.1, 2.2),
(b) Providing at least one parameter indicative of a technical condition of the at least one medium voltage cable (2.1, 2.2),
(c) Determining a fault probability of the at least one medium voltage cable (2.1, 2.2) based on the at least one provided parameter, and
(d) Partial discharge measurement of the at least one medium voltage cable (2.1, 2.2), provided that the determined fault probability is above the specified limit value.

2. The method (100) of claim 1, wherein a plurality of parameters are provided and the fault probability is determined while determining a weighting of the plurality of provided parameters.

3. The method (100) according to claim 1 or 2, wherein a plurality of medium voltage cables (2.1, 2.2) are partial discharge measured, wherein the order of partial discharge measurements of the medium voltage cables (2.1, 2.2) is determined based on the fault probability of each medium voltage cable (2.1, 2.2), and/or
wherein the at least one parameter relates to the at least one medium voltage cable (2.1, 2.2), in particular a design, a material, an age and/or a length of a section (4.1, 4.2, 4.3, 4.4, 4.5) of the at least one medium voltage cable (2.1, 2.2).

4. The method (100) according to any one of the preceding claims, wherein the at least one parameter comprises at least one connecting component (5.1, 5.2, 5.3) of parts (4.1, 4.2, 4.3, 4.4. 4.5) of the medium voltage cable (2.1, 2.2), in particular a design, a material and/or an age of the at least one connecting component (5.1, 5.2, 5.3).

5. The method (100) according to any one of the preceding claims, wherein the at least one parameter is empirically based on previously detected disturbances from the at least one medium voltage cable (2.1, 2.2) and/or previously detected conditions from the at least one medium voltage cable (2.1, 2.2).

6. The method (100) according to any one of the preceding claims, wherein said at least one parameter relates to at least one of a soil type in which said at least one medium voltage cable (2.1, 2.2) is embedded and/or an infrastructure environment under which said at least one medium voltage cable (2.1, 2.2) is located.

7. The method (100) according to any one of the preceding claims, wherein the partial discharge measurement is carried out by a cable measuring carriage (30) which is driven to a network station (3.1, 3.2, 3.3) of the at least one medium voltage cable (2.1, 2.2), in particular for the partial discharge measurement.

8. The method (100) according to claim 7, wherein a receiving unit (32) of the cable measuring carriage (30) receives a deployment signal for the partial discharge measurement, provided that the determined fault probability of the at least one medium voltage cable (2.1, 2.2) is above the defined limit value.

9. The method (100) according to claim 8, wherein the deployment signal contains information about a network station (3.1, 3.2, 3.3) of the at least one medium-voltage cable (2.1, 2.2), in particular
wherein the information includes an address, geographic coordinates, a designation and/or status information of the network station (3.1, 3.2, 3.3).

10. The method (100) according to any one of claims 7 to 9, wherein at least one drone (33) captures images of network stations (3.1, 3.2, 3.3) at respective ends of the at least one medium voltage cable (2.1, 2.2) and one of the two network stations (3.1, 3.2, 3.3) is determined as the network station (3.1, 3.2, 3.3) for the partial discharge measurement based on the images.

11. The method (100) according to claim 10, wherein the at least one drone (33) further captures images along the ground (6), in particular a road, below which the at least one medium voltage cable (3.1, 3.2, 3.3) runs.

12. A system (10) comprising a measurement device (31) for performing a partial discharge measurement and a computer (20), wherein the system (10) is adapted to perform the method (100) according to any one of the preceding claims.

13. The system (10) according to claim 12, wherein the system (10) comprises a cable measuring carriage (30) comprising at least the measuring device (31).

14. A computer program product comprising instructions that cause the system (10) of claim 12 or 13 to perform the method (100) of any one of claims 1 to 11.

15. A computer readable storage medium (23) on which is stored the computer program product of claim 14.

## Revendications

1. Procédé (100) de mesure de décharge partielle d'au moins un câble moyenne tension (2.1, 2.2) d'un réseau moyenne tension (1), le procédé comprenant les étapes suivantes
(a) La définition d'une valeur limite pour une probabilité de perturbation de l'au moins un câble moyenne tension (2.1, 2.2),
(b) La mise à disposition d'au moins un paramètre qui est indicatif d'un état technique de l'au moins un câble moyenne tension (2.1, 2.2),
(c) Déterminer une probabilité de perturbation de l'au moins un câble moyenne tension (2.1, 2.2) à l'aide de l'au moins un paramètre mis à disposition, et
(d) Mesure de décharge partielle de l'au moins un câble moyenne tension (2.1, 2.2), dans la mesure où la probabilité de perturbation déterminée est supérieure à la valeur limite definée.

2. Procédé (100) selon la revendication 1, dans lequel plusieurs paramètres sont mis à disposition et la probabilité de perturbation est déterminée en définissant une pondération des plusieurs paramètres mis à disposition.

3. Procédé (100) selon la revendication 1 ou 2, dans lequel plusieurs câbles moyenne tension (2.1, 2.2) sont mesurés en décharge partielle, l'ordre des mesures de décharge partielle des câbles moyenne tension (2.1, 2.2) étant déterminé à l'aide de la probabilité de perturbation de chaque câble moyenne tension (2.1, 2.2), et/ou l'au moins un paramètre concernant l'au moins un câble moyenne tension (2.1, 2.2), en particulier un type de construction, un matériau, un âge et/ou une longueur d'un tronçon (4.1, 4.2, 4.3, 4.4, 4.5) de l'au moins un câble moyenne tension (2.1, 2.2).

4. Procédé (100) selon l'une des revendications précédentes, dans lequel le au moins un paramètre comprend au moins un composant de liaison (5.1, 5.2, 5.3) de pièces partielles (4.1, 4.2, 4.3, 4.4. 4.5) du câble moyenne tension (2.1, 2.2), notamment un type de construction, un matériau et/ou un âge du au moins un composant de liaison (5.1, 5.2, 5.3).

5. Procédé (100) selon l'une quelconque des revendications précédentes, dans lequel ledit au moins un paramètre est basé empiriquement sur des perturbations précédemment détectées dudit au moins un câble moyenne tension (2.1, 2.2) et/ou sur des conditions précédemment détectées dudit au moins un câble moyenne tension (2.1, 2.2).

6. Procédé (100) selon l'une des revendications précédentes, dans lequel ledit au moins un paramètre concerne au moins un type de sol dans lequel ledit au moins un câble moyenne tension (2.1, 2.2) est enfoui et/ou un environnement d'infrastructure sous lequel ledit au moins un câble moyenne tension (2.1, 2.2) se trouve.

7. Procédé (100) selon l'une des revendications précédentes, dans lequel la mesure de décharge partielle est effectuée par un chariot de mesure de câble (30) qui est conduit, en particulier pour la mesure de décharge partielle, à une station de réseau (3.1, 3.2, 3.3) du au moins un câble moyenne tension (2.1, 2.2).

8. Procédé (100) selon la revendication 7, dans lequel une unité de réception (32) du chariot de mesure de câble (30) reçoit un signal d'intervention pour la mesure de décharge partielle, dans la mesure où la probabilité de perturbation déterminée de l'au moins un câble moyenne tension (2.1, 2.2) est supérieure à la valeur limite fixée.

9. Procédé (100) selon la revendication 8, dans lequel le signal d'intervention contient une information sur une station de réseau (3.1, 3.2, 3.3) de l'au moins un câble moyenne tension (2.1, 2.2), en particulier
l'information contenant une adresse, des coordonnées géographiques, une désignation et/ou des informations d'état de la station de réseau (3.1, 3.2, 3.3).

10. Procédé (100) selon l'une des revendications 7 à 9, dans lequel au moins un drone (33) prend des images de stations de réseau (3.1, 3.2, 3.3) aux extrémités respectives de l'au moins un câble moyenne tension (2.1, 2.2) et, à l'aide des images, l'une des deux stations de réseau (3.1, 3.2, 3.3) est déterminée comme station de réseau (3.1, 3.2, 3.3) pour la mesure de décharge partielle.

11. Procédé (100) selon la revendication 10, dans lequel ledit au moins un drone (33) prend en outre des images le long du sol (6), en particulier d'une route sous laquelle ledit au moins un câble moyenne tension (3.1, 3.2, 3.3) s'étend.

12. Système (10) comprenant un dispositif de mesure (31) pour effectuer une mesure de décharge partielle et un ordinateur (20), le système (10) étant adapté pour mettre en oeuvre le procédé (100) selon l'une quelconque des revendications précédentes.

13. Système (10) selon la revendication 12, dans lequel le système (10) comprend un chariot de mesure de câbles (30) qui comprend au moins le dispositif de mesure (31).

14. Produit programme d'ordinateur comprenant des instructions qui font que le système (10) de la revendication 12 ou 13 exécute le procédé (100) selon l'une quelconque des revendications 1 à 11.

15. Support de stockage lisible par ordinateur (23) sur lequel est stocké le produit programme d'ordinateur selon la revendication 14.
